(19) Europäisches Patentamt
European Patent Office
Office européen des brevets

(11) **EP 3 012 876 B1**

(12) **FASCICULE DE BREVET EUROPEEN**

(45) Date de publication et mention de la délivrance du brevet:
**04.11.2020 Bulletin 2020/45**

(51) Int Cl.:
*H01L 31/103* *(2006.01)*    *H01L 31/0352* *(2006.01)*
*H01L 31/0296* *(2006.01)*    *H01L 31/0304* *(2006.01)*
*H01L 21/266* *(2006.01)*

(21) Numéro de dépôt: **15190397.8**

(22) Date de dépôt: **19.10.2015**

(54) **PROCEDE DE FABRICATION D'UNE PHOTODIODE A FAIBLE BRUIT**

HERSTELLUNGSVERFAHREN EINER RAUSCHARMEN FOTODIODE

METHOD FOR MANUFACTURING A LOW-NOISE PHOTODIODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.10.2014 FR 1402360**

(43) Date de publication de la demande:
**27.04.2016 Bulletin 2016/17**

(73) Titulaire: **Commissariat à l'Énergie Atomique et aux Énergies Alternatives 75015 Paris (FR)**

(72) Inventeurs:
• **GRAVRAND, Olivier**
  **38120 FONTANIL CORNILLON (FR)**
• **ROTHMAN, Johan**
  **38000 GRENOBLE (FR)**

(74) Mandataire: **Brevalex**
  **56, Boulevard de l'Embouchure**
  **B.P. 27519**
  **31075 Toulouse Cedex 2 (FR)**

(56) Documents cités:
JP-B2- 2 955 983      US-A- 4 791 467
US-A1- 2003 071 221      US-A1- 2007 034 898
US-A1- 2008 067 620

**Description**

**DOMAINE TECHNIQUE**

La présente invention concerne le domaine des procédés de fabrication d'une photodiode, utilisée notamment pour détecter un rayonnement infrarouge.

**ÉTAT DE LA TECHNIQUE ANTÉRIEURE**

On connaît dans l'art antérieur différentes sortes de photodiodes, qui sont utilisées par exemple dans le domaine spatial, pour la détection du rayonnement infrarouge, notamment l'infrarouge moyen (longueurs d'onde comprises entre 4 $\mu$m et 5 $\mu$m), et l'infrarouge lointain (longueurs d'onde supérieures à 5 $\mu$m).
Une photodiode comprend une couche en matériau semi-conducteur, dans laquelle une jonction PN sépare une première région dopée, d'une deuxième dopée également nommée région d'absorption. Dans tout le texte, toute cette couche en matériau semi-conducteur est nommée « couche utile ». Un photon à la longueur d'onde souhaitée est absorbé dans la région d'absorption, où il crée un porteur dit minoritaire. Ce porteur minoritaire diffuse dans la couche utile jusqu'à atteindre la jonction PN, où il va être à l'origine d'un courant électrique de recombinaison de porteurs. La diffusion des porteurs minoritaires jusqu'à la jonction PN est nommée « collection par diffusion ».
Une photodiode présente généralement un courant dit courant d'obscurité, correspondant à un courant électrique de recombinaison de porteurs dans la photodiode, ne correspondant pas à l'absorption d'un rayonnement électromagnétique. Le courant d'obscurité correspond à du bruit, et dégrade les performances en détection infrarouge.
On connaît dans l'art antérieur un procédé de fabrication d'une photodiode planaire, comprenant la réalisation d'une couche utile consistant en une couche supérieure faite d'un alliage de cadmium mercure tellure $Cd_yHg_{1-y}Te$, y = 0,28, et une couche inférieure en $Cd_xHg_{1-x}Te$, x = 0,22. On réalise ensuite une jonction PN s'enfonçant dans la couche utile légèrement plus profondément que la couche supérieure. On obtient ainsi une photodiode à faible bruit permettant de détecter des longueurs d'onde dans l'infrarouge lointain. Une telle photodiode est décrite dans l'article « MBE HgCdTe Heterostructure p-on-n Planar Infrared Photodiodes », J.M. Arias & al., Journal of Electronic Materials, Vol. 22, No. 8, 1993.
On a montré que dans un matériau semi-conducteur en $Cd_xHg_{1-x}Te$, la bande interdite, nommée « gap », dépend de la concentration en cadmium. Plus cette concentration est élevée, plus le gap est élevé. Ainsi, dans la photodiode décrite par J.M. Arias & *al.,* la couche supérieure à fort gap permet de diminuer le bruit, tandis que la couche inférieure à faible gap permet de détecter un photon à la longueur d'onde souhaitée.
Le diagramme d'énergie d'une jonction PN classique correspond à une bande de valence qui croît régulièrement depuis le niveau d'énergie correspondant au dopage N vers le niveau d'énergie correspondant au dopage P. Dans le cas d'une jonction PN telle que décrite dans l'article de J.M. Arias & *al.,* et lorsque la jonction PN s'enfonce moins profondément dans la couche utile que la limite entre la couche supérieure et la couche inférieure, la bande de valence présente une évolution différente. Son niveau d'énergie commence par décroître, du fait du gradient de bande interdite, à l'interface entre la couche inférieure et la couche supérieure. Ensuite, ce niveau d'énergie augmente vers le niveau d'énergie correspondant au dopage P. La décroissance du niveau d'énergie de la bande de valence forme une barrière de potentiel, qui entrave la diffusion des porteurs minoritaires jusqu'à la jonction PN.
Un inconvénient de la photodiode telle que décrite par J.M. Arias & *al.* est donc que le positionnement de la jonction PN reste une étape délicate.

- si la jonction PN s'enfonce trop dans la couche inférieure, cela se traduit par une augmentation du bruit de la photodiode ;
- si la jonction PN ne débouche pas dans la couche inférieure, le gap élevé de la couche supérieure forme une barrière de potentiel qui entrave la diffusion des porteurs minoritaires jusqu'à la jonction PN. La collection par diffusion des porteurs minoritaires sera donc entravée. Ainsi, l'absorption d'un photon formera bien un porteur minoritaire dans région d'absorption de la photodiode, mais celui-ci ne pourra pas atteindre la jonction PN, et ne pourra donc pas être à l'origine d'un courant dans la photodiode.

On connaît dans l'art antérieur le document US 4,791,467, qui décrit une photodiode formée dans un empilement d'une couche supérieure à fort gap, sur une couche inférieure à faible gap. Dans ce document, la jonction PN s'enfonce jusque dans la couche à faible gap.
Le document US 2003/0071221, décrit également une photodiode dans laquelle une jonction PN s'étend dans une couche supérieure à gap élevé, jusque dans une couche inférieure, dite d'absorption, de gap légèrement plus faible.
Dans le document US 2008/0067620, il est décrit une photodiode dans laquelle la jonction PN suit le contour d'une tranchée creusée dans une couche utile, en traversant différentes couches, dont une couche inférieure dont le gap croît au fur et à mesure que l'on s'enfonce dans la photodiode.

Dans le document JP 2 955983, il est enseigné une façon de réaliser une région dopée, qui préserve la qualité de la surface d'implantation, tout en offrant une bonne qualité de la jonction PN.

Enfin, le document US 2007/0034898 décrit une photodiode formée dans une couche supérieure à fort gap, s'étendant au-dessus d'une couche inférieure à faible gap. En fonctionnement, la zone de déplétion s'étend jusque dans la couche inférieure à faible gap, grâce à une forte polarisation en inverse.

Un objectif de la présente invention est de proposer un procédé de fabrication d'une photodiode à faible bruit, ne présentant pas les inconvénients de l'art antérieur.

En particulier, un but de la présente invention est de proposer un procédé particulièrement simple pour fabriquer une photodiode à faible bruit.

L'invention concerne également une photodiode pouvant être obtenue à l'aide d'un procédé selon l'invention.

## EXPOSÉ DE L'INVENTION

Cet objectif est atteint avec un procédé de fabrication d'une photodiode comprenant une couche utile en un alliage semi-conducteur, la couche utile présentant une valeur de bande interdite décroissante depuis une première face dite face supérieure vers une face opposée dite face inférieure, ledit procédé comprenant une étape de réalisation d'une première région dopée située dans la couche utile et formant une jonction PN avec une deuxième région dopée de la couche utile, ladite réalisation d'une première région dopée comprenant :

- une première étape de dopage, de façon à réaliser une partie formant base de la première région dopée ; et
- une deuxième étape de dopage, de façon à réaliser au moins une protubérance de la première région dopée, ladite protubérance faisant saillie depuis la partie formant base et en direction de la face inférieure de la couche utile, de sorte que la valeur moyenne de bande interdite dans la protubérance soit inférieure à la valeur moyenne de bande interdite dans la partie formant base.

Selon une premier mode de réalisation, la première étape de dopage comprend une première implantation ionique mettant en œuvre une première énergie d'implantation et une première surface d'implantation ; et

- la deuxième étape de dopage comprend une deuxième implantation ionique, mettant en œuvre une deuxième énergie d'implantation et une deuxième surface d'implantation, la deuxième énergie d'implantation étant supérieure à la première énergie d'implantation, et la deuxième surface d'implantation étant au moins deux fois inférieure à la première surface d'implantation.

Selon un second mode de réalisation, la première étape de dopage comprend une diffusion de dopant, mettant en œuvre une première surface de diffusion ; et

- la deuxième étape de dopage comprend une implantation ionique mettant en œuvre une deuxième surface d'implantation, la deuxième surface d'implantation étant au moins deux fois inférieure à la première surface de diffusion.

L'invention concerne également un procédé de fabrication d'une matrice de photodiodes, dans lequel chaque photodiode est fabriquée par un procédé de fabrication tel que défini ci-dessus, les plusieurs premières régions dopées étant situées dans une même couche utile et formant chacune une jonction PN avec une deuxième région dopée commune aux photodiodes.

Ce procédé comprend avantageusement une étape de réalisation d'au moins une zone dite sur-dopée, située dans la deuxième région dopée et entre deux jonctions PN voisines, la zone sur-dopée présentant une densité de dopage supérieure à celle d'au moins une zone dite d'absorption située dans la deuxième région dopée et sous chaque jonction PN.

La zone sur-dopée est obtenue par exemple lors d'une croissance par épitaxie de la couche utile, par réalisation d'une couche sur-dopée de couche utile, affleurant la face supérieure de la couche utile, et formant, après réalisation des premières régions dopées, la zone sur-dopée.

L'invention concerne aussi une photodiode comprenant une couche utile en un alliage semi-conducteur, la couche utile présentant :

- une valeur de bande interdite décroissante, depuis une première face de la couche utile dite face supérieure vers une face opposée dite face inférieure, et
- une jonction PN, entre une première région dopée et une deuxième région dopée entourant la première région dopée ;

la première région dopée comprenant :

- une partie formant base ; et
- au moins une protubérance, faisant saillie depuis la partie formant base et en direction de la face inférieure de la couche utile, de sorte que la valeur moyenne de bande interdite dans la protubérance soit inférieure à la valeur moyenne de bande interdite dans la partie formant base.

Avantageusement, la protubérance :

- s'étend dans la couche utile au moins 1,2 fois plus profondément que la partie formant base et
- présente une section dans un plan parallèle au plan de la face supérieure de la couche utile, au moins deux fois inférieure à la section de la partie formant base dans un plan parallèle au plan de la face supérieure de la couche utile.

Selon un premier mode de réalisation, la couche utile consiste en une couche utile inférieure présentant une première valeur de bande interdite et une couche utile supérieure présentant une deuxième valeur de bande interdite supérieure à ladite première valeur, la base s'étendant uniquement dans la couche utile supérieure et la protubérance s'étendant au moins dans la couche utile inférieure.

Selon un second mode de réalisation, la couche utile présente une variation continue de valeur de bande interdite, celle-ci décroissant depuis la face supérieure vers la face inférieure de la couche utile.

La couche utile est par exemple en un alliage semi-conducteur de cadmium, mercure et tellure de type $Cd_xHg_{1-x}Te$, ou un alliage semi-conducteur d'indium, gallium et arsenic de type $In_xGa_{1-x}As$, ou un alliage semi-conducteur d'indium, arsenic, antimoine de type $InAs_xSb_{1-x}$.

Selon une première variante, la première région dopée présente une unique protubérance positionnée au centre de la partie formant base.

Selon une seconde variante, la première région dopée présente au moins deux protubérances situées en périphérie de la partie formant base.

L'invention concerne enfin une matrice de photodiodes dans laquelle les photodiodes sont des photodiodes telles que définies ci-dessus, les plusieurs premières régions dopées étant situées dans une même couche utile et formant chacune une jonction PN avec une deuxième région dopée commune aux photodiodes.

Avantageusement, la deuxième région dopée comprend :

- au moins une zone dite d'absorption, située sous chaque jonction PN ; et
- au moins une zone dite sur-dopée, située entre deux jonctions PN voisines, et présentant une densité de dopage supérieure à celle de la zone d'absorption.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

- la figure 1A illustre de manière schématique un premier mode de réalisation de procédé de fabrication d'une photodiode selon l'invention,
- la figure 1B illustre de manière schématique une vue en coupe de la photodiode obtenue à l'aide du procédé de la figure 1A ;
- la figure 1C illustre une variante du procédé de la figure 1A ;
- la figure 2 illustre de manière schématique une étape d'un premier mode de réalisation de procédé de fabrication d'une matrice de photodiodes selon l'invention, et une vue en coupe de la matrice de photodiodes obtenue ;
- la figure 3A illustre de manière schématique une étape d'un deuxième mode de réalisation de procédé de fabrication d'une matrice de photodiodes selon l'invention ;
- la figure 3B illustre une vue en coupe de la matrice de photodiodes, obtenue à l'aide du procédé de la figure 3A ;
- les figures 4A et 4B illustrent de manière schématique, selon une vue en coupe et une vue de dessus, un troisième mode de réalisation d'une matrice de photodiodes selon l'invention ; et
- les figures 5A et 5B illustrent de manière schématique, selon une vue en coupe et une vue de dessus, un quatrième mode de réalisation d'une matrice de photodiodes selon l'invention.

## EXPOSÉ DÉTAILLÉ DE MODES DE RÉALISATION PARTICULIERS

L'invention concerne une photodiode planaire et son procédé de fabrication, ainsi qu'une matrice planaire de telles photodiodes. On peut définir une photodiode planaire (respectivement une matrice de photodiodes planaire), comme présentant une couche supérieure en matériau semi-conducteur ayant une surface supérieure plane, sans trou qui ne soit pas entièrement comblé par un connecteur électrique.

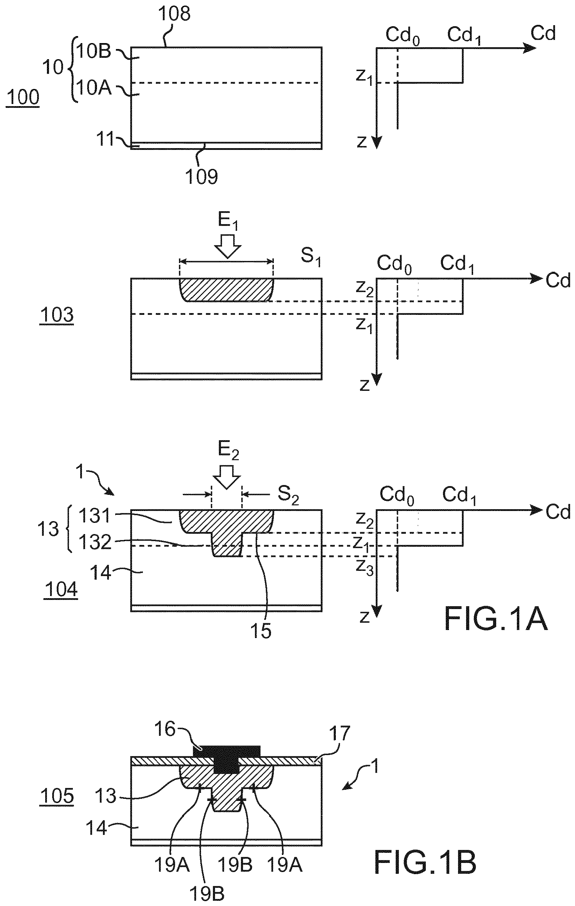

On a illustré en figure 1A, et de façon schématique, les étapes d'un procédé selon l'invention de fabrication photodiode. Les vues de la figure 1A sont des vues en coupe.

Etape 100 :

On dispose initialement d'une couche dite couche utile 10 en matériau semi-conducteur, par exemple en un alliage de cadmium, mercure et tellure $Cd_xHg_{1-x}Te$, avec x un réel compris entre 0 et 1, les bornes étant exclues.

En variante, la couche utile 10 est en matériau semi-conducteur fait d'un alliage d'indium, gallium et arsenic $In_xGa_{1-x}As$, avec x un réel compris entre 0 et 1, les bornes étant exclues.

La couche utile 10 peut également être en matériau semi-conducteur fait d'un alliage d'indium, arsenic et antimoine $InAs_xSb_{1-x}$, avec x un réel compris entre 0 et 1, les bornes étant exclues.

Dans un matériau semi-conducteur en $Cd_xHg_{1-x}Te$ ou en $In_xGa_{1-x}As$ ou en $InAs_xSb_{1-x}$ ou en $In_{1-x}Al_xSb$ la bande interdite, nommée « gap », dépend de la concentration en cadmium, respectivement en indium, respectivement en arsenic, respectivement en aluminium. On pourra imaginer de nombreuses variantes dans lesquelles la couche utile 10 est formée de n'importe quel alliage semi-conducteur, dans lequel le gap dépend de la concentration en l'un des composants de l'alliage.

La couche utile 10 présente typiquement une épaisseur comprise entre 3 $\mu$m et 20 $\mu$m, par exemple 6 $\mu$m.

Cette couche utile 10 est réalisée ici sur un substrat 11, transparent aux longueurs d'onde que l'on souhaite détecter. Selon une variante non représentée, le substrat est séparé de la couche utile avant, pendant ou après la mise en œuvre du procédé selon l'invention.

Pour des raisons de clarté des figures, l'épaisseur du substrat 11 est sous dimensionnée sur les figures.

La couche utile présente par exemple une forme de parallélépipède, notamment un parallélépipède rectangle. On définit dans cette couche utile un axe z partant de la face 108, reliant les faces 108 et 109, et définissant l'axe de la profondeur. La face 109 est une face inférieure, ici au contact du substrat 11. La face 108 est une face supérieure, du côté opposé à la face inférieure 109.

La couche utile 10 présente un gradient de la valeur de bande interdite, celle-ci décroissant depuis la face supérieure 108 vers la face inférieure 109. Ce gradient de la valeur de bande interdite correspond ici à un gradient de la concentration en cadmium. Il pourra s'agir selon les cas d'un gradient de la concentration en Indium dans $In_xGa_{1-x}As$, ou d'un gradient d'un composant dans tout autre alliage semi-conducteur, dans lequel la valeur de bande interdite dépend de la concentration de ce composant dans de l'alliage.

Dans l'exemple illustré en figure 1A, le gradient est discontinu. En particulier, la couche utile 10 consiste en une couche utile supérieure 10B déposée directement sur une couche utile inférieure 10A, les couches utiles inférieures et supérieures présentant chacune une composition sensiblement constante dans l'espace. La couche utile supérieure 10B présente une valeur de bande interdite supérieure à celle de la couche utile inférieure 10A. Une telle couche utile est formée par exemple en faisant varier la composition d'un matériau source lors de la croissance de la couche utile. Cette croissance est notamment une croissance par épitaxie.

Il peut s'agir d'une épitaxie par jet moléculaire. On forme par exemple la couche utile inférieure 10A, puis la couche utile supérieure 10B, en modifiant la composition des éléments déposés par épitaxie, notamment en modifiant la concentration en un composant de la couche utile déterminant sa valeur de bande interdite. Un exemple réalisation d'une telle couche utile est décrit notamment dans l'article de J.M. Arias & *al.,* présenté en introduction, ainsi que par Tennant *et al*. dans la demande de brevet US 2007/0034898. Ici, la couche utile supérieure 10B présente donc une concentration en cadmium supérieure à la concentration en cadmium dans la couche utile inférieure 10A. On a représenté à droite le gradient de la concentration en cadmium Cd en fonction de la profondeur z dans la couche utile.

Pour z compris entre 0 et $z_1$, la concentration en cadmium prend une première valeur $Cd_1$. $z_1$ correspond à l'épaisseur de la couche utile supérieure 10A. Par exemple $Cd_1$ est compris entre x=0,95 et x=0,5.

Pour z supérieur à $z_1$, la concentration en cadmium prend une valeur $Cd_0$. Par exemple $Cd_0$ est compris entre x=0,2 et x=4.

On a par exemple $Cd_1$ supérieur ou égal à $1,5* Cd_0$.

Etape 101 :

Au cours de l'étape 101, on réalise une première implantation ionique dans la couche utile 10. Cette implantation ionique met en œuvre une énergie d'implantation $E_1$, et une surface d'implantation $S_1$. En d'autres termes, on envoie des éléments dopants à l'intérieur de la couche utile avec une énergie $E_1$ et en les faisant traverser une surface $S_1$ de la face supérieure 108 de la couche utile.

On choisit ici l'énergie $E_1$ de sorte qu'une jonction PN formée grâce à cette implantation ionique s'étende depuis la face supérieure 108 de la couche utile, et sur une profondeur $z_2$ inférieure à $z_1$.

On a représenté à droite la profondeur $z_2$ sur le graphique du gradient de concentration en cadmium dans la couche utile. On voit que la concentration en cadmium à la profondeur $z=z_2$ correspond à la concentration en cadmium $Cd_1$ dans la couche utile supérieure.

L'homme du métier saura aisément définir une valeur d'énergie $E_1$, étant donné qu'il n'est aucunement nécessaire d'être précis. Dans l'exemple illustré en figure 1A, tant que $z_2$ est inférieure à $z_1$, l'objectif sera atteint.

Etape 102 :

Au cours de l'étape 102, on réalise une deuxième implantation ionique dans la couche utile 10. Cette implantation ionique met en œuvre une énergie d'implantation $E_2$, et une surface d'implantation $S_2$.

L'énergie d'implantation $E_2$ est supérieure à l'énergie d'implantation $E_1$, de sorte que les éléments dopants implantés à l'étape 102 s'étendent plus profondément dans la couche utile que les éléments dopants implantés à l'étape 101. En particulier, on choisit ici l'énergie $E_2$ de sorte qu'une jonction PN formée grâce à cette implantation ionique s'étende depuis la face supérieure 108 de la couche utile, et sur une profondeur $z_3$ supérieure à $z_1$.

On a représenté à droite la profondeur $z_3$ sur le graphique du gradient de concentration en cadmium dans la couche utile. On voit que la concentration en cadmium à la profondeur $z=z_3$ correspond à la concentration en cadmium $Cd_0$ dans la couche utile inférieure.

L'homme du métier saura aisément définir une valeur d'énergie $E_2$, étant donné qu'il n'est aucunement nécessaire d'être précis. Dans l'exemple illustré en figure 1A, tant que $z_3$ est supérieure à $z_1$, l'objectif sera atteint.

La surface d'implantation $S_2$ est plus de deux fois inférieure à la surface d'implantation $S_1$, de sorte que les éléments dopants implantés à l'étape 102 s'étendent sur une zone bien plus étroite que les éléments dopants implantés à l'étape 101. Par exemple, la surface $S_1$ est un carré de 10 $\mu$m de côté, et la surface $S_2$ est un carré de 1 $\mu$m de côté.

L'ordre entre les étapes 101 et 102 peut être échangé. On peut prévoir de recouvrir la face supérieure 108 d'une résine, puis d'insoler la résine par lithographie de façon à y ménager une ouverture traversante de surface $S_1$, respectivement $S_2$, à travers laquelle on réalise l'implantation ionique.

Grâce aux éléments dopants implantés aux étapes 101 et 102, on forme dans la couche utile 10 une première région dopée 13 formant une jonction PN 15 avec une deuxième région dopée 14 de la couche utile. Une jonction PN 15 forme une photodiode.

Une région est dite dopée P lorsqu'elle présente un excès de « trous » (porteur majoritaire), ou en d'autres termes un défaut d'électrons (porteurs minoritaires). Une région est dite dopée N lorsqu'elle présente un excès d'électrons (porteur majoritaire), ou en d'autres termes un défaut de trous (porteurs minoritaires). La première région dopée 13 affleure la face supérieure 108, et présente un dopage N ou P. La deuxième région dopée 14 présente un dopage P ou N de type différent, et entoure la première région dopée 13 latéralement et du côté de la face inférieure 109.

La création d'une jonction PN par implantation ionique peut mettre en œuvre, de façon bien connue de l'homme du métier, des étapes supplémentaires de recuit et/ou d'activation des éléments dopants implantés.

Par exemple, on réalise la première région dopée 13 par deux implantations successives d'arsenic (dopant P) dans une couche utile en $Cd_xHg_{1-x}Te$. En particulier, on réalise deux implantations successives d'arsenic. On réalise ensuite un recuit à environ 400°C pour activer l'arsenic. Ce recuit crée des lacunes de mercure dans toute la couche utile 10. On obtient donc une région fortement dopée P (grâce à l'implantation d'arsenic) et une région faiblement dopée P (à cause des lacunes de mercure). La région fortement dopée P forme la première région dopée 13. On réalise ensuite un recuit à environ 200°C sous pression saturante de mercure pour combler les lacunes de mercure. La région faiblement dopée P devient dopée N, et forme la deuxième région dopée 14.

En variante, on réalise la première région dopée 13 par deux implantations successives de bore (dopant N) dans une couche utile en $Cd_xHg_{1-x}Te$. Pour cela, dans une première étape, on réalise un recuit pour ajuster le niveau de lacunes de mercure, de façon à doper P l'ensemble de la couche utile. Après les implantations de bore, on obtient donc une première région dopée 13, dopée N, et une deuxième région dopée 14, dopée P.

L'homme du métier saura mettre en œuvre les étapes nécessaires pour réaliser une jonction PN par implantation ionique dans d'autres matériaux tels que l'$In_xGa_{1-x}As$ ou l'$InAs_xSb_{1-x}$.

Selon l'invention, la première région dopée 13 présente :

- une partie formant base 131, réalisée grâce à la première étape de dopage 101 ; et
- une protubérance 132, faisant saillie depuis la partie formant base 131 et en direction de la face inférieure 109.

La valeur moyenne de bande interdite dans la protubérance 132 est inférieure à la valeur moyenne de bande interdite dans la partie formant base 131.

Dans le mode de réalisation représenté en figure 1A, la valeur de bande interdite présente une rupture brutale à l'interface entre la couche utile supérieure et la couche utile inférieure. Dans ce cas, le procédé selon l'invention est mis en œuvre de façon à ce que la partie formant base 131 se trouve entièrement dans la couche utile supérieure, et la protubérance 132 se trouve au moins en partie dans la couche utile inférieure. La protubérance se trouve par exemple sur plus de la moitié de son volume, dans la couche utile inférieure.

On définit la section de la partie formant base 131 comme étant sa section dans un plan parallèle à la face supérieure 108, situé typiquement à mi-hauteur entre la face supérieure 108 et la profondeur maximale de la partie formant base 131. On définit la section de la protubérance 132 comme étant sa section dans un plan parallèle à la face supérieure 108, situé typiquement à mi-hauteur entre la profondeur maximale de la partie formant base 131 et la profondeur maximale de la protubérance 132. Typiquement, la section de la partie formant base 131 est deux fois, voire quatre fois et même dix fois plus grande que la section de la protubérance 132. On considère que la section de la partie formant base 131 correspond à la surface d'implantation $S_1$, et la section de la protubérance correspond à la surface d'implantation $S_2$.

Selon une variante du procédé selon l'invention, la partie formant base 131 est réalisée par diffusion d'éléments dopants. La protubérance 132 peut également être réalisée par diffusion d'éléments dopants, bien qu'on préfère une implantation ionique.

La figure 1B illustre la photodiode 1 obtenue grâce au procédé selon l'invention. La photodiode 1 est représentée selon une vue en coupe dans un plan orthogonal au plan de la face supérieure 108. Sur la figure 1B, la première région dopée 13 présente une forme en T, correspondant à une protubérance 132 faisant saillie depuis le centre de la partie formant base 131.

On peut remarquer qu'une protubérance 132 se traduit sur cette vue en coupe par des points d'inflexion sur la section de la jonction PN 15. Un point d'inflexion correspond à un changement de signe du rayon de courbure, ou en d'autre terme un changement de concavité (courbe passant du type concave à convexe, ou inversement). Deux couples comprenant un point d'inflexion supérieur 19A (du côté de la face supérieure 108) et un point d'inflexion inférieur 19B (du côté de la face inférieure 109) encadrent chacun un angle arrondi formé entre la partie formant base 131 et la protubérance 132.

On pourra réaliser une matrice de photodiodes selon l'invention, à partir d'une couche utile dans laquelle on forme plusieurs premières régions dopées 13, formant chacun une jonction PN avec une deuxième région dopée 14 commune.

On va maintenant expliquer les avantages de la mise en œuvre du procédé selon l'invention, et de la photodiode ainsi obtenue.

Le bruit d'une photodiode présente diverses sources :

- le courant de diffusion, qui peut être fortement réduit en diminuant la température d'utilisation de la photodiode ; et
- le courant de génération-recombinaison qui diminue plus lentement avec la température.

Le courant de génération-recombinaison est donc la source de bruit qui détermine les performances d'une photodiode à basse température.

Le courant de génération-recombinaison comprend notamment le courant de génération-recombinaison dit de zone de charge d'espace (ZCE). La zone de charge d'espace, nommée également zone de déplétion, s'étend à proximité de la jonction PN, et de part et d'autre de celle-ci. Elle est dépourvue de porteurs libres et constituée de deux zones chargées électriquement.

Le courant de génération-recombinaison de ZCE est créé par une génération spontanée d'une paire électron-trou dans la zone de charge d'espace, ne correspondant pas à l'absorption d'un photon dans la couche utile. Ainsi, on mesure dans la photodiode un courant ne correspondant pas à l'absorption d'un photon incident.

Le courant de génération-recombinaison de ZCE est proportionnel au volume de la première région dopée 13, et a une dépendance exponentielle vis-à-vis du gap dans la ZCE :

$$I_{GR} = I_0 V e^{\frac{-E_g}{2kT}} \qquad (1)$$

avec $I_{GR}$ le courant de génération-recombinaison de ZCE, $I_0$ une constante, T la température, k la constante de Boltzmann, V le volume de la première région dopée 13, et $E_g$ le gap dans la zone de charge d'espace.

On voit donc que pour diminuer le courant de génération-recombinaison de ZCE, on peut diminuer le volume V et/ou augmenter le gap dans la ZCE.

Si on joue sur la valeur du gap dans la couche utile, on doit maintenir un faible gap du côté de la face inférieure 109, là où un photon incident à la longueur d'onde souhaitée va créer un porteur minoritaire dans la couche utile. Il est possible de maintenir une détection infrarouge dans un matériau petit gap, du côté de la face inférieure 109, et de reléguer la ZCE dans un matériau plus grand gap, du côté de la face supérieure 108. On minimise ainsi le bruit de génération-recombinaison dans la ZCE (courants de fuite), tout en détectant les longueurs d'onde souhaitées, notamment dans l'infrarouge moyen ou l'infrarouge lointain.

Comme précisé en introduction, cette caractéristique seule présente cependant comme inconvénient que le positionnement de la jonction PN est délicat.

Or, selon l'invention, la première région dopée 13 est réalisée par :

- une première étape de dopage formant une partie formant base 131 qui va être à l'origine d'un courant de génération-recombinaison de ZCE $I_{GR1}$; et
- une deuxième étape de dopage formant une protubérance 132 qui va être à l'origine d'un courant de génération-recombinaison de ZCE $I_{GR2}$.

Ainsi, le courant de génération-recombinaison de ZCE total s'exprime ainsi :

$$I_{GR} = I_{GR1} + I_{GR2} = I_{01}V_1 e^{\frac{-E_{g1}}{2kT}} + I_{02}V_2 e^{\frac{-E_{g2}}{2kT}} \qquad (2)$$

avec T la température, k la constante de Boltzmann, $I_{01}$ et $I_{02}$ des constantes, $V_1$ le volume de la partie formant base 131, $V_2$ le volume de la protubérance 132, $E_{g1}$ le gap dans la zone de charge d'espace située autour de la partie formant base 131 (ici autour d'une profondeur $z_1$ dans la couche utile) et $E_{g2}$ le gap dans la zone de charge d'espace située autour de la protubérance 132 (ici autour d'une profondeur $z_2$ dans la couche utile).

La valeur moyenne de bande interdite $E_{g1}$ dans la partie formant base 131 est supérieure à la valeur moyenne de bande interdite $E_{g2}$ dans la protubérance 132.

Le courant de génération-recombinaison de ZCE présente deux contributions :

- $I_{GR1}$, dont la valeur dépend de $V_1$ et $E_{g1}$. $E_{g1}$ est élevé ce qui contribue à diminuer la valeur de $I_{GR1}$.
- $I_{GR2}$, dont la valeur dépend de $V_2$ et $E_{g2}$. $V_2$ est petit ce qui contribue à diminuer la valeur de $I_{GR2}$.

Ainsi, le positionnement de la jonction PN ne présente pas de grande contrainte :

- la partie formant base 131 peut se trouver entièrement dans une zone à fort gap, puisque ce n'est pas elle qui collecte les porteurs minoritaires.
- les porteurs minoritaires sont collectés grâce à la protubérance 132 qui, puisque son volume est réduit, peut se trouver entièrement dans une zone à faible gap tout en ne contribuant que très faiblement au bruit de la matrice de photodiodes. En d'autres termes, la faible valeur de $V_2$ permet d'avoir une faible valeur de $I_{GR2}$. En outre, la faible valeur de $E_{g2}$ évite la formation d'une barrière de potentiel repoussant les porteurs minoritaires à distance de la jonction PN 15.

En d'autres termes, une barrière de potentiel repoussant les porteurs minoritaires est percée par la jonction PN, au niveau de la protubérance 132. Grâce à la partition en deux parties de la première région dopée 13, la protubérance 132 s'étend nettement au-delà de cette barrière de potentiel, sans conséquence néfaste sur le bruit de la photodiode. En d'autres termes, ce percement est franc : la jonction PN ne fait pas qu'affleurer la barrière de potentiel, mais se place nettement à distance de celle-ci. On s'assure ainsi que les porteurs minoritaires soient efficacement collectés par la jonction PN, au niveau de la protubérance 132. La photodiode 1 selon l'invention présente donc un rendement quantique élevé.

En outre, lorsque l'on réalise une matrice de photodiodes 1 selon l'invention, ce percement franc de la barrière de potentiel par la jonction PN assure une homogénéité du rendement quantique de la matrice. Une telle homogénéité est difficilement atteignable avec une jonction PN affleurant la barrière de potentiel. En effet, le positionnement de la jonction PN selon l'axe z de la profondeur est difficilement maîtrisable, et peut donc varier d'une photodiode à l'autre sur une même matrice. Cela conduit à des performances disparates selon que la jonction PN se trouve juste au-dessus de la barrière de potentiel ou juste au-dessous de la barrière de potentiel.

L'invention offre donc un procédé particulièrement simple pour fabriquer une photodiode 1 planaire, présentant à la fois un faible bruit, et un rendement quantique élevé.

L'invention est particulièrement intéressante dans le cas d'une première région 13 dopée P, sur une deuxième région 14 dopée N.

On remarque que le fait que la largeur de la jonction PN accessible aux porteurs minoritaires soit faible relativement à la largeur de la photodiode (respectivement au pas de la matrice de photodiodes) n'est pas problématique.

Le cas échéant, il sera possible de prévoir une faible densité de dopage dans la deuxième région dopée 14, afin d'augmenter la longueur de diffusion des porteurs minoritaires dans cette région.

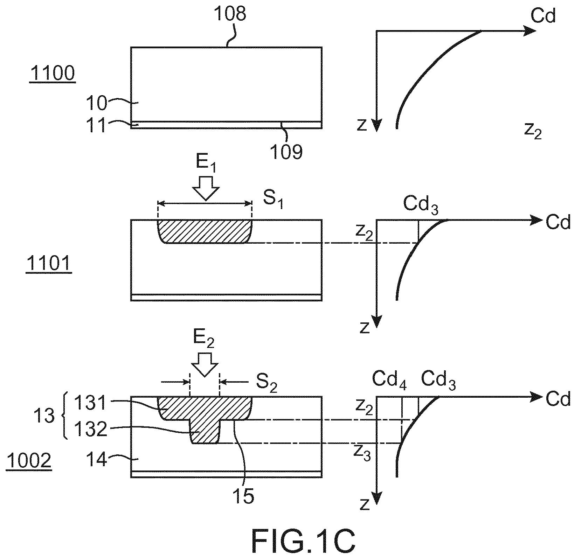

La figure 1C illustre une variante du procédé de la figure 1A. Ce mode de réalisation ne sera décrit que pour ses différences relativement au mode de réalisation de la figure 1A.

Etape 1100 :

Selon le mode de réalisation de la figure 1C, la couche utile présente initialement un gradient de valeur de bande interdite, celle-ci variant de manière décroissante et continue, depuis la face supérieure 108 de la couche utile vers sa face inférieure 109. Cette variation continue correspond par exemple à une variation de bande interdite inférieure à 10%, sur une épaisseur de couche utile d'environ 100 nm.

Un tel gradient est par exemple réalisé lors de la croissance par épitaxie de la couche utile, en faisant varier continument la composition du matériau source.

Le gradient de valeur de bande interdite correspond ici à un gradient de concentration en cadmium tel que représenté à droite. La concentration en cadmium dans la couche utile décroît par exemple, depuis x=0,95 jusqu'à x=0,2.

Les étapes 1101 et 1102 correspondent respectivement aux étapes 101 et 102 décrites en référence à la figure 1A. Cependant, le choix des énergies d'implantation $E_1$ et $E_2$ présente encore moins de contraintes. En effet, puisque la valeur de la bande interdite décroît continûment depuis la face supérieure 108 vers la face inférieure 109, il suffit que $E_2$ soit supérieur à $E_1$ pour que la valeur moyenne de bande interdite dans la protubérance soit forcément inférieure à la valeur moyenne de bande interdite dans la partie formant base. Aucune précaution n'est nécessaire pour obtenir ce résultat. Cette variante est donc particulièrement avantageuse.

On définit la profondeur de la partie formant base 131 comme étant sa profondeur maximale dans la couche utile. On définit la profondeur de la protubérance 132 comme étant sa profondeur maximale dans la couche utile. Typiquement, la protubérance 132 s'étend plus profondément de 0,2 à 0,5 $\mu$m dans la couche utile. La protubérance 132 s'étend par exemple un tiers plus profondément dans la couche utile que la partie formant base 131, grâce à une énergie d'implantation $E_2$ deux à cinq fois plus élevée que $E_1$. L'énergie d'implantation $E_2$ est par exemple de l'ordre de 50 à 500 keV, pour une implantation d'arsenic.

On peut considérer les critères suivants :

- la protubérance 132 doit s'étendre dans la couche utile jusqu'à une profondeur où le gap est tel que la différence entre ce gap et le gap minimum dans la couche utile est inférieur à kT où k est la constante de Boltzmann. En d'autres termes : $Eg(Cd_2) - Eg(Cd_0) < kT$, notamment $Eg(Cd_2) - Eg(Cd_0) < 0,8*kT$ ; et
- la partie formant base 131 doit s'étendre dans la couche utile à une profondeur la plus faible possible, où le gap est tel que la différence entre ce gap et le gap minimum dans la couche utile est supérieur à kT. En d'autres termes :

$$Eg(Cd_1) - Eg(Cd_0) > kT, \text{ notamment } Eg(Cd_2) - Eg(Cd_0) > 1,2*kT.$$

En effet, le caractère bloquant de la barrière de potentiel est lié au rapport $\Delta E_g/kT$ avec k=8,6.10$^{-5}$ eV/K. Expérimentalement, les inventeurs ont relevé que $\Delta E_g \approx kT$ était la différence de gap limite au-delà de laquelle les photo-porteurs sont bloqués. En particulier, les inventeurs ont relevé que pour une hauteur de barrière de potentiel estimée à $\Delta E_g$ = 6 à 8 meV, le blocage des photo-porteurs a lieu à partir de T<70 K, ce qui correspond à $\Delta E_g \approx kT$.

Ce mode de réalisation de l'invention est particulièrement avantageux pour une utilisation d'une photodiode à basse température (par exemple une température inférieure à 70 K), puisqu'à ces températures les porteurs minoritaires manquent d'énergie pour passer une éventuelle barrière de potentielle avant d'accéder à la jonction PN. Ainsi, il est avantageux de diminuer encore la barrière de potentiel à passer grâce à la protubérance 132.

Le procédé selon l'invention peut être suivi par des étapes classiques d'installation d'éléments de contact électrique. En particulier, un élément de contact électrique 16 peut être installé au contact de la première région dopée 13. L'élément de contact électrique 16 permet de polariser électriquement la photodiode. L'élément de contact électrique 16 est typiquement réalisé par une gravure dans la première région dopée 13 puis dépôt d'un métal de prise de contact. La gravure peut traverser une éventuelle couche de passivation 17 recouvrant la couche utile 10. Typiquement, le contact électrique 16 présente un diamètre minimum de 4 $\mu$m, dans sa partie en contact avec la première région dopée 13. La première région dopée 13 présente donc, au niveau de la face supérieure 108, une largeur minimale de 6 $\mu$m.

On peut prévoir également (non représenté), un élément de contact électrique installé au contact de la deuxième région dopée 14, et qui peut être commun à toutes les photodiodes d'une matrice de photodiodes.

Comme exposé ci-dessus, la contribution au bruit de la partie formant base 131 dépend de $V_1$ et $Eg_1$. Grâce à l'invention, on peut positionner la partie formant base 131 entièrement dans une zone à gap élevé. On peut donc recourir à de grandes valeurs de $V_1$ sans conséquences dramatiques sur le bruit de la matrice de photodiodes. De

grandes valeurs de $V_1$ peuvent correspondre à une grande section de la première région dopée 13 du côté de la face supérieure 108. Cela facilite le positionnement de l'élément de contact électrique 16, au contact de la première région dopée 13. L'invention est donc particulièrement avantageuse dans le cadre de la fabrication photodiodes et matrices de photodiodes de faibles dimensions, notamment de matrices de photodiodes planaires de pas inférieur ou égal à 15 μm.

On peut noter que la gravure d'une prise de contact électrique peut former une petite zone dopée N au niveau de la gravure. Il est donc crucial de positionner l'élément de contact électrique 16 au contact de la première région dopée 13, notamment lorsqu'elle est dopée P, afin d'éviter des courts-circuits de la jonction PN.

Dans l'art antérieur, il peut apparaître des canaux de conduction, en surface, entre des jonctions PN voisines, réunissant ainsi un ou plusieurs pixels de la matrice de photodiodes. Ces canaux de conduction peuvent être formés par des imperfections d'une couche de passivation i déposée sur la face supérieure 108 de la couche utile. Ces canaux de conductions apparaissent plus particulièrement lorsque la couche utile présente un faible gap, et sont plus problématiques lorsque deux jonctions PN voisines sont proches (petit pas de matrice). Or, selon l'invention :

- les portions de jonction PN situées dans un matériau faible gap peuvent être éloignées les unes des autres (protubérance) ; et
- les portions de jonction PN proches les unes des autres peuvent se trouver dans un matériau grand gap (partie formant base).

On réalise ainsi aisément une matrice de photodiodes à faible pas, et dans laquelle des pixels voisins ne se rejoignent pas. L'invention est particulièrement avantageuse dans le cas de matrices de photodiodes de grandes dimensions, par exemple des matrices de 640x512 photodiodes.

Dans certains cas, le gap élevé en surface ne suffit pas à s'affranchir des canaux de conduction, en surface. On détaillera dans la suite une solution pour s'affranchir tout de même des canaux de conduction en surface.

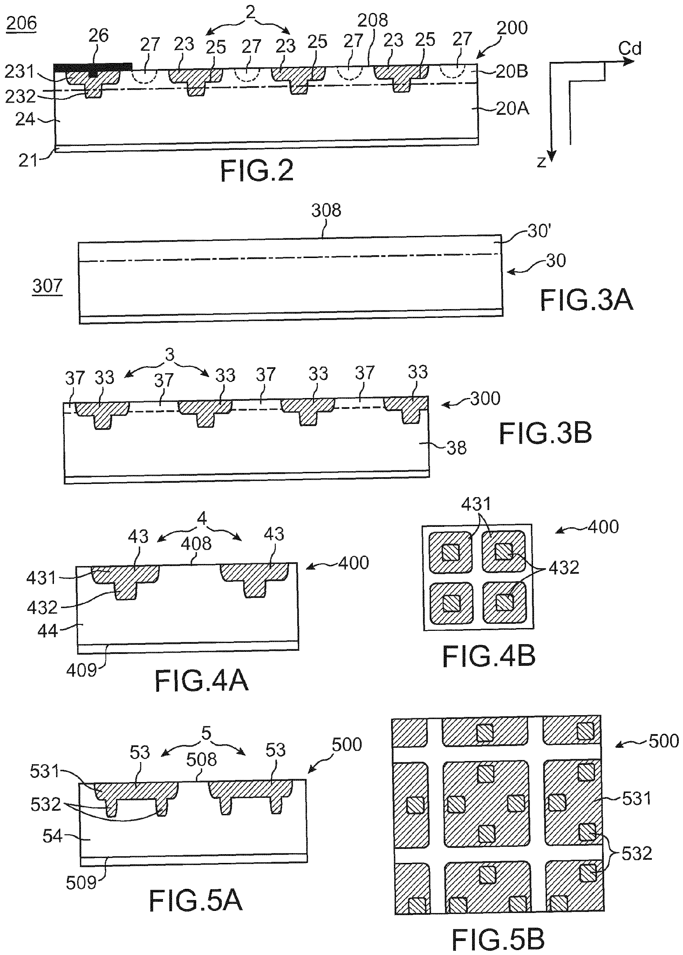

On a représenté en figure 2 une étape 206 d'un premier mode de réalisation de procédé selon l'invention, permettant de réaliser une matrice 200 de photodiodes 2 selon l'invention. Les références numériques 2, 21, 20A, 20B, 23, 24, 25, 231, 232 de la figure 2, correspondent aux références numériques 1, 11, 10A, 10B, 13, 14, 15, 131, 132 de la figure 1A.

Le deuxième mode de réalisation selon l'invention comprend les étapes du procédé tel qu'illustré en figure 1A, mises en œuvre pour former chaque photodiode de la matrice de photodiodes. Ces étapes sont suivies de l'étape 206.

La couche utile consiste donc en une couche utile inférieure 20A et une couche utile supérieure 20B. Chaque première région dopée 23 selon l'invention se compose d'une partie formant base 231 située dans la couche utile supérieure 20B, et une protubérance 232 située dans la couche utile inférieure 20A.

En variante, l'étape 206 est réalisée suite à la mise en œuvre des étapes du procédé tel qu'illustré en figure 1C, pour former chaque photodiode de la matrice de photodiodes.

Cette étape est ici mise en œuvre suite à la réalisation de plusieurs premières régions dopées 23, formant chacune une jonction PN avec une deuxième région dopée commune.

Au cours de l'étape 206, on réalise plusieurs zones sur-dopée 27, situées entre deux jonctions PN 25 voisines, dans la deuxième région dopée. Les zones sur-dopées 27 affleurent la face supérieure 208 de la couche utile.

Le dopage des zones sur-dopées 27 est de même type que celui de la deuxième région dopée commune. Les zones sur-dopées 27 présentent une densité de dopage supérieure à la densité de dopage dans le restant de la deuxième région dopée. En d'autres termes, les zones sur-dopées 27 présentent une densité de dopage supérieure à la densité de dopage dans une zone dite d'absorption 28 située dans la deuxième région dopée, notamment sous chaque jonction PN. Par exemple, la densité de dopage des zones sur-dopées 27 est au moins dix fois supérieure à la densité de dopage de la zone d'absorption 28. Typiquement, la densité de dopage est de $10^{16}$ atomes/cm$^3$ dans les zones sur-dopées 27, et de $10^{15}$ atomes/cm$^3$ dans la zone d'absorption 28.

Les zones sur-dopées 27 peuvent être réalisées par implantation ionique entre deux jonctions PN 25 voisines.

Les zones sur-dopées 27 peuvent s'étendre rectilignement entre les jonctions PN, et former un maillage régulier. Les zones sur-dopées 27 forment ainsi des lignes conductrices, ce qui diminue les effets de charge à l'origine des canaux de conduction, en surface.

Ces lignes conductrices sont avantageusement reliées électriquement à un contact électrique de polarisation de la deuxième région dopée. Ainsi, on diminue la résistance perçue par une photodiode éloignée de ce contact électrique. On s'affranchit ainsi des difficultés liées à la dépolarisation des photodiodes centrales dans des matrices de photodiodes de grandes dimensions. On évite ainsi de devoir implanter des contacts électriques intermédiaires dans la deuxième région dopée, et entre des jonctions PN. Cette caractéristique est particulièrement avantageuse pour des petits pas de matrice (inférieurs à 15 μm, par exemple 12 μm ou 10 μm), et/ou lorsque la deuxième région dopée est dopée P (porteurs majoritaires peu mobiles).

Puisque les zones sur-dopées 27 et les premières régions dopées 23 sont voisines dans une partie de la couche utile présentant un gap élevé, on s'affranchit d'éventuels effets tunnels entre les zones sur-dopées 27 et les premières régions dopées 23.

Les zones sur-dopées 27 peuvent s'étendre profondément dans la couche utile, mais on préfèrera qu'elles s'étendent au maximum sur la même profondeur que les parties formant base 231 des premières régions dopées 23.

On peut prévoir d'utiliser les contacts électriques 26 s'enfonçant dans les premières régions dopées 23, pour réaliser un masque au travers duquel on réalise l'implantation ionique formant les zones sur-dopées 27. Sur la figure 2, on a représenté un seul contact électrique 26, par souci de clarté de la figure.

La présence des zones sur-dopées 27 permet de recourir à de faibles densités de dopage dans la deuxième région dopée, par exemple dopée N. Cela donne accès à de grandes longueurs de diffusion des porteurs minoritaires dans cette région et assure de collecter tous les porteurs minoritaires à l'aide des seules portions de jonction PN correspondant aux protubérances. Par exemple, la densité de dopage dans la deuxième région dopée est de $10^{15}$ atomes/cm$^3$, soit une longueur de diffusion des porteurs minoritaires d'environ 20 $\mu$m.

La figure 3A illustre de manière schématique une étape 307 d'un deuxième mode de réalisation de procédé selon l'invention pour fabriquer une matrice de photodiodes.

Cette étape 307 est ici mise en œuvre avant la réalisation de plusieurs premières régions dopées 33, formant chacune une jonction PN avec une deuxième région dopée commune.

Au cours de l'étape 307, on réalise une couche sur-dopée 30' de couche utile, présentant une plus forte concentration en éléments dopants que le reste de la couche utile 30. La couche sur-dopée 30' est située du côté de la face supérieure 308 de la couche utile 30. Elle est formée par exemple en insérant des éléments dopants dans les éléments que l'on utilise pour la croissance par épitaxie de la couche utile 30. Par exemple, on incorpore de l'indium lors de la croissance d'une couche utile en $Cd_xHg_{1-x}Te$, ce qui correspondra ensuite à une forte densité de dopage N.

La couche utile 30 peut comprendre une couche utile supérieure et une couche utile inférieure, présentant chacune une valeur de bande interdite différente. Dans ce cas, la couche sur-dopée 30' fait partie de la couche utile supérieure. L'épaisseur de la couche sur-dopée 30' est donc inférieure à l'épaisseur de la couche utile supérieure, par exemple deux fois inférieure.

La couche utile peut présenter une variation continue de valeur de bande interdite. La couche sur-dopée 30' fait partie d'une telle couche utile, et présente donc également une variation continue de valeur de bande interdite. L'épaisseur de la couche sur-dopée 30' est faible devant l'épaisseur totale de la couche utile, par exemple au moins quatre fois inférieure.

Ainsi, après réalisation des premières régions dopées 33, et éventuelle activation des éléments dopants dans la couche sur-dopée 30', on obtient une matrice 300 telle que représentée en figure 3B. Les références numériques 300, 33, 3, 37 de la figure 3B, correspondent aux références numériques 200, 23, 2, 27 de la figure 2.

Les zones sur-dopées 37 sont adjacentes aux premières régions dopées 33. Elles correspondent aux portions de la couche sur-dopée 30' ne recevant pas une première région dopée 33.

De préférence, l'épaisseur des zones sur-dopées 37 est inférieure ou égale à l'épaisseur de la partie formant base dans chaque première région dopée 33.

Il est possible de réaliser des zones sur-dopées 37 adjacentes aux premières régions dopées 33, sans dégrader les performances optiques de la matrice 300 de photodiodes 3, grâce à un gap suffisamment élevé dans la couche utile sur toute la profondeur correspondant à ces zones sur-dopées 37. Cette caractéristique est rendue possible grâce à la réalisation en deux parties des premières régions dopées 33 : on réalise ce gap élevé sur toute la profondeur correspondant à ces zones sur-dopées 37, et les protubérances selon l'invention s'étendent jusqu'à une profondeur dans la couche utile ou le gap est plus faible.

Les figures 4A et 4B illustrent de manière schématique, selon une vue en coupe et respectivement une vue de dessus, un troisième mode de réalisation d'une matrice 400 de photodiodes 4 selon l'invention.

Selon ce mode de réalisation, chaque première région dopée 43 présente une unique protubérance 432, qui est positionnée de façon centrale relativement à la partie formant base 431. Comme décrit en référence à la figure 1, chaque première région dopée 43 présente une forme en T, selon une vue en coupe dans un plan orthogonal à la face supérieure 408 de la couche utile.

Les figures 5A et 5B illustrent de manière schématique, selon une vue en coupe et respectivement une vue de dessus, un quatrième mode de réalisation d'une matrice 500 de photodiodes 5 selon l'invention.

Selon ce mode de réalisation, chaque première région dopée 53 présente quatre protubérances 532, positionnées en périphérie relativement à la partie formant base 531. En particulier, selon une vue de dessus, chaque partie formant base 531 présente une forme de carré, et les protubérances 532 sont positionnées au milieu de chaque côté du carré. Ainsi, deux protubérances 532 de deux premières régions dopées 53 voisines sont proches l'une de l'autre.

On a remarqué que la FTM de la matrice de photodiodes est meilleure lorsque les protubérances 532 de premières régions dopées voisines sont proches les unes des autres. Bien que surprenante, cette observation peut s'expliquer par le fait que la probabilité qu'un porteur minoritaire soit collecté par une jonction PN A et ne soit pas collecté par la jonction PN voisine B varie d'autant plus rapidement dans l'espace que les jonctions PN A et B sont rapprochées.

En réalisant plusieurs protubérances 532 dans une même première région dopée 53, on peut à la fois diminuer le bruit en réduisant l'étendue latérale totale des protubérances 532, et améliorer la FTM en disposant chaque protubérance 532 à proximité d'une protubérance 532 appartenant à une première région dopée voisine.

On remarque que l'utilisation de plusieurs protubérances 532 permet en outre de s'assurer de collecter l'ensemble des porteurs minoritaires, si leur longueur de diffusion s'avérait trop faible relativement au pas de la matrice et à l'étendue latérale d'une seule protubérance 532. Cela pourrait être le cas si l'on choisissait d'augmenter la densité de dopage (par exemple à $10^{16}$ atomes/cm$^3$) dans toute la deuxième région dopée 54, par exemple pour lutter contre des canaux de conduction. Dans ce cas, la longueur de diffusion des porteurs minoritaires serait réduite, d'où une très bonne FTM mais des difficultés à collecter tous les porteurs minoritaires pour un pas de matrice trop élevé et à l'aide d'une unique protubérance 532 dans chaque première région dopée 53.

**Revendications**

1. Procédé de fabrication d'une photodiode (1 ; 3 ; 4 ; 5) comprenant une couche utile (10; 20; 30) en un alliage semi-conducteur, la couche utile présentant une valeur de bande interdite décroissante depuis une première face dite face supérieure (108 ; 208 ; 308 ; 408 ; 508) vers une face opposée dite face inférieure (109 ; 409 ; 509), ledit procédé comprenant une étape de réalisation d'une première région dopée (13 ; 23 ; 33 ; 43 ; 53) située dans la couche utile et formant une jonction PN (15 ; 25) avec une deuxième région dopée (14 ; 24 ; 44 ; 54) de la couche utile, **caractérisé en ce que** la réalisation de la première région dopée comprend:

   - une première étape de dopage (103), de façon à réaliser une partie formant une base (131 ; 231 ; 431 ; 531) de la première région dopée ; et
   - une deuxième étape de dopage (104), de façon à réaliser au moins une protubérance (132 ; 232 ; 432 ; 532) de la première région dopée, ladite protubérance faisant saillie depuis la partie formant la base et en direction de la face inférieure (109 ; 409 ; 509) de la couche utile, de sorte que la valeur moyenne de bande interdite dans la protubérance (132 ; 232 ; 432 ; 532) soit inférieure à la valeur moyenne de bande interdite dans la partie formant la base (131; 231 ; 431 ; 531).

2. Procédé selon la revendication 1, **caractérisé en ce que** :

   - la première étape de dopage (103) comprend une première implantation ionique mettant en œuvre une première énergie ($E_1$) d'implantation et une première surface d'implantation ($S_1$) ; et
   - la deuxième étape de dopage (104) comprend une deuxième implantation ionique, mettant en œuvre une deuxième énergie d'implantation ($E_2$) et une deuxième surface d'implantation ($S_2$), la deuxième énergie d'implantation étant supérieure à la première énergie d'implantation, et la deuxième surface d'implantation étant au moins deux fois inférieure à la première surface d'implantation.

3. Procédé selon la revendication 1, **caractérisé en ce que** :

   - la première étape de dopage comprend une diffusion de dopant, mettant en œuvre une première surface de diffusion ; et
   - la deuxième étape de dopage comprend une implantation ionique mettant en œuvre une deuxième surface d'implantation, la deuxième surface d'implantation étant au moins deux fois inférieure à la première surface de diffusion.

4. Procédé de fabrication d'une matrice de photodiodes (200 ; 300 ; 400 ; 500), **caractérisé en ce que** chaque photodiode est fabriquée par un procédé de fabrication selon l'une quelconque des revendications 1 à 3, les plusieurs premières régions dopées (13 ; 23 ; 33 ; 43 ; 53) étant situées dans une même couche utile (10 ; 20 ; 30) et formant chacune une jonction PN (15 ; 25) avec une deuxième région dopée (14 ; 24 ; 44 ; 54) commune aux photodiodes.

5. Procédé de fabrication d'une matrice de photodiodes (200 ; 300) selon la revendication 4, **caractérisé par** une étape (206 ; 307) de réalisation d'au moins une zone dite sur-dopée (27 ; 37), située dans la deuxième région dopée (24) et entre deux jonctions PN (25) voisines, la zone sur-dopée (27 ; 37) présentant une densité de dopage supérieure à celle d'au moins une zone dite d'absorption (28 ; 38) située dans la deuxième région dopée (24) et sous chaque jonction PN (25).

6. Procédé de fabrication d'une matrice de photodiodes (300) selon la revendication 5, **caractérisé en ce que** la zone sur-dopée (37) est réalisée lors d'une croissance par épitaxie de la couche utile, par réalisation (307) d'une couche sur-dopée (30') de couche utile, affleurant la face supérieure (308) de la couche utile, et formant, après réalisation des premières régions dopées (33), la zone sur-dopée (37).

**7.** Photodiode (1 ; 2 ; 3 ; 4 ; 5) comprenant une couche utile (10 ; 30) en un alliage semi-conducteur, la couche utile présentant :

- une valeur de bande interdite décroissante, depuis une première face de la couche utile dite face supérieure (108 ; 208 ; 308 ; 408 ; 508) vers une face opposée dite face inférieure (109 ; 409 ; 509), et
- une jonction PN (15 ; 25), entre une première région dopée (13 ; 23 ; 33 ; 43 ; 53) et une deuxième région dopée (14 ; 24 ; 44; 54) entourant la première région dopée ; **caractérisée en ce que** la première région dopée (13 ; 23 ; 33 ; 43 ; 53) comprend :
- une partie formant une base (131 ; 231 ; 431 ; 531) ; et
- au moins une protubérance (132 ; 232 ; 432 ; 532), faisant saillie depuis la partie formant la base (131 ; 231 ; 431 ; 531) et en direction de la face inférieure (109 ; 409 ; 509) de la couche utile, de sorte que la valeur moyenne de bande interdite dans la protubérance (132 ; 232 ; 432 ; 532) soit inférieure à la valeur moyenne de bande interdite dans la partie formant la base (131 ; 231 ; 431; 531).

**8.** Photodiode (1 ; 2 ; 3 ; 4 ; 5) selon la revendication 7, **caractérisée en ce que** la protubérance (132 ; 232 ; 432 ; 532) :

- s'étend dans la couche utile (10 ; 30) au moins 1,2 fois plus profondément que la partie formant la base (131 ; 231 ; 431; 531) ; et
- présente une section dans un plan parallèle au plan de la face supérieure de la couche utile, au moins deux fois inférieure à la section de la partie formant la base (131 ; 231 ; 431 ; 531) dans un plan parallèle au plan de la face supérieure de la couche utile.

**9.** Photodiode (1 ; 2) selon la revendication 7 ou 8, **caractérisée en ce que** la couche utile consiste en une couche utile inférieure (10A ; 20A) présentant une première valeur de bande interdite et une couche utile supérieure (10B ; 20B) présentant une deuxième valeur de bande interdite supérieure à ladite première valeur, et **en ce que** la base (131 ; 231) s'étend uniquement dans la couche utile supérieure (10B ; 20B) et que la protubérance (132 ; 232) s'étend au moins dans la couche utile inférieure (10A ; 20A).

**10.** Photodiode selon la revendication 7 ou 8, **caractérisée en ce que** la couche utile (10) présente une variation continue de valeur de bande interdite, celle-ci décroissant depuis la face supérieure (108) vers la face inférieure (109) de la couche utile.

**11.** Photodiode (1 ; 3 ; 4 ; 5) selon l'une quelconque des revendications 7 à 10, **caractérisée en ce que** la couche utile (10 ; 20 ; 30) est en un alliage semi-conducteur de cadmium, mercure et tellure de type $Cd_xHg_{1-x}Te$, ou un alliage semi-conducteur d'indium, gallium et arsenic de type $In_xGa_{1-x}As$, ou un alliage semi-conducteur d'indium, arsenic, antimoine de type $InAs_xSb_{1-x}$.

**12.** Photodiode (1 ; 3 ; 4) selon l'une quelconque des revendications 7 à 11, **caractérisée en ce que** la première région dopée (13 ; 23 ; 33 ; 43) présente une unique protubérance (132 ; 232 ; 432) positionnée au centre de la partie formant la base (131 ; 231; 431).

**13.** Photodiode (5) selon l'une quelconque des revendications 7 à 11, **caractérisée en ce que** la première région dopée (53) présente au moins deux protubérances (532) situées en périphérie de la partie formant la base (531).

**14.** Matrice de photodiodes (200 ; 300 ; 400 ; 500), **caractérisée en ce que** les photodiodes sont des photodiodes selon l'une quelconque des revendications 7 à 13, les plusieurs premières régions dopées (13 ; 23 ; 33 ; 43 ; 53) étant situées dans une même couche utile (10 ; 20 ; 30) et formant chacune une jonction PN (15 ; 25) avec une deuxième région dopée (14 ; 24 ; 44 ; 54) commune aux photodiodes.

**15.** Matrice de photodiodes (200 ; 300) selon la revendication 14, **caractérisée en ce que** la deuxième région dopée (24) comprend :

- au moins une zone dite d'absorption (28 ; 38), située sous chaque jonction PN (25) ; et
- au moins une zone dite sur-dopée (27 ; 37), située entre deux jonctions PN (25) voisines, et présentant une densité de dopage supérieure à celle de la zone d'absorption (28 ; 38).

EP 3 012 876 B1

**Patentansprüche**

**1.** Verfahren zur Herstellung einer Fotodiode (1; 3; 4; 5) mit einer Nutzschicht (10; 20; 30) aus einer Halbleiterlegierung, wobei die Nutzschicht einen Bandlückenwert aufweist, der von einer ersten Seite, Oberseite (108; 208; 308; 408; 508) genannt, zu einer gegenüberliegenden Seite, Unterseite (109; 409; 509), hin abnimmt, wobei das Verfahren einen Schritt des Bildens eines ersten dotierten Bereichs (13; 23; 33; 43; 53) umfasst, der sich in der Nutzschicht befindet und einen PN-Übergang (15; 25) mit einem zweiten dotierten Bereich (14; 24; 44; 54) der Nutzschicht bildet, **dadurch gekennzeichnet, dass** das Bilden des ersten dotierten Bereichs umfasst:

- einen ersten Schritt des Dotierens (103), um so einen Basisabschnitt (131; 231; 431; 531) des ersten dotierten Bereichs zu bilden; und
- einen zweiten Schritt des Dotierens (104), um so zumindest einen Vorsprung (132; 232; 432; 532) des ersten dotierten Bereichs zu bilden, wobei der Vorsprung von dem Basisabschnitt in Richtung der Unterseite (109; 409; 509) der Nutzschicht vorsteht, so dass der mittlere Bandlückenwert in dem Vorsprung (132; 232; 432; 532) niedriger ist als der mittlere Bandlückenwert in dem Basisabschnitt (131; 231; 431; 531).

**2.** Verfahren nach Anspruch 1, **dadurch gekennzeichnet, dass**:

- der erste Schritt des Dotierens (103) eine erste Ionenimplantation unter Verwendung einer ersten Implantationsenergie ($E_1$) und einer ersten Implantationsfläche ($S_1$) umfasst; und
- der zweite Schritt des Dotierens (104) eine zweite Ionenimplantation unter Verwendung einer zweiten Implantationsenergie ($E_2$) und einer zweiten Implantationsfläche ($S_2$) umfasst, wobei die zweite Implantationsenergie höher als die erste Implantationsenergie ist und die zweite Implantationsfläche höchstens halb so groß wie die erste Implantationsfläche ist.

**3.** Verfahren nach Anspruch 1, **dadurch gekennzeichnet, dass**:

- der erste Dotierungsschritt eine Dotierstoffdiffusion unter Verwendung einer ersten Diffusionsfläche umfasst; und
- der zweite Dotierungsschritt eine Ionenimplantation unter Verwendung einer zweiten Implantationsfläche umfasst, wobei die zweite Implantationsfläche höchstens halb so groß wie die erste Diffusionsfläche ist.

**4.** Verfahren zur Herstellung einer Fotodiodenmatrix (200; 300; 400; 500), **dadurch gekennzeichnet, dass** jede Fotodiode durch ein Herstellungsverfahren nach einem der Ansprüche 1 bis 3 hergestellt wird, wobei die mehreren ersten dotierten Bereiche (13; 23; 33; 43; 53) in derselben Nutzschicht (10; 20; 30) angeordnet sind und jeweils einen PN-Übergang (15; 25) mit einem zweiten, den Fotodioden gemeinsamen dotierten Bereich (14; 24; 44; 54) bilden.

**5.** Verfahren zur Herstellung einer Fotodiodenmatrix (200; 300) nach Anspruch 4, **gekennzeichnet durch** einen Schritt (206; 307) des Bildens zumindest einer sogenannten überdotierten Zone (27; 37), die sich in dem zweiten dotierten Bereich (24) und zwischen zwei benachbarten PN-Übergängen (25) befindet, wobei die überdotierte Zone (27; 37) eine Dotierungsdichte aufweist, die höher ist als die von zumindest einer sogenannten Absorptionszone (28; 38), die sich in dem zweiten dotierten Bereich (24) und unter jedem PN-Übergang (25) befindet.

**6.** Verfahren zur Herstellung einer Fotodiodenmatrix (300) nach Anspruch 5, **dadurch gekennzeichnet, dass** die überdotierte Zone (37) während eines epitaktischen Wachstums der Nutzschicht durch Bildung (307) einer überdotierten Schicht (30') der Nutzschicht gebildet wird, die mit der Oberseite (308) der Nutzschicht bündig ist und nach der Bildung der ersten dotierten Bereiche (33) die überdotierte Zone (37) bildet.

**7.** Fotodiode (1; 2; 3; 4; 5) mit einer Nutzschicht (10; 30) aus einer Halbleiterlegierung, wobei die Nutzschicht aufweist:

- einen Bandlückenwert, der von einer ersten Seite der Nutzschicht, Oberseite (108; 208; 308; 408; 508) genannt, zu einer gegenüberliegenden Seite, Unterseite (109; 409; 509) genannt, hin abnimmt und
- einen PN-Übergang (15; 25) zwischen einem ersten dotierten Bereich (13; 23; 33; 43; 53) und einem zweiten dotierten Bereich (14; 24; 44; 54), der den ersten dotierten Bereich umgibt;

**dadurch gekennzeichnet, dass** der erste dotierte Bereich (13; 23; 33; 43; 53) aufweist:

14

- einen Basisabschnitt (131; 231; 431; 531); und
- zumindest einen Vorsprung (132; 232; 432; 532), der von dem Basisabschnitt (131; 231; 431; 531) in Richtung der Unterseite (109; 409; 509) der Nutzschicht hin vorsteht, so dass der mittlere Bandlückenwert im Vorsprung (132; 232; 432; 532) niedriger ist als der mittlere Bandlückenwert im Basisabschnitt (131; 231; 431; 531).

8. Fotodiode (1; 2; 3; 4; 5) nach Anspruch 7, **dadurch gekennzeichnet, dass** der Vorsprung (132; 232; 432; 532)

   - sich zumindest 1,2-mal tiefer in die Nutzschicht (10; 30) erstreckt als der Basisabschnitt (131; 231; 431; 531); und
   - einen Querschnitt in einer Ebene parallel zur Ebene der Oberseite der Nutzschicht aufweist, der höchstens halb so groß ist wie der Querschnitt des Basisabschnitts (131; 231; 431; 531) in einer Ebene parallel zur Ebene der Oberseite der Nutzschicht.

9. Fotodiode (1; 2) nach Anspruch 7 oder 8, **dadurch gekennzeichnet, dass** die Nutzschicht aus einer unteren Nutzschicht (10A; 20A) mit einem ersten Bandlückenwert und einer oberen Nutzschicht (10B; 20B) mit einem zweiten Bandlückenwert, der höher als der erste Wert ist, besteht, und dass sich die Basis (131; 231) nur in der oberen Nutzschicht (10B; 20B) erstreckt und der Vorsprung (132; 232) sich zumindest in der unteren Nutzschicht (10A; 20A) erstreckt.

10. Fotodiode nach Anspruch 7 oder 8, **dadurch gekennzeichnet, dass** die Nutzschicht (10) eine kontinuierliche Veränderung des Bandlückenwertes aufweist, wobei dieser von der Oberseite (108) zur Unterseite (109) der Nutzschicht hin abnimmt.

11. Fotodiode (1; 3; 4; 5) nach einem der Ansprüche 7 bis 10, **dadurch gekennzeichnet, dass** die Nutzschicht (10; 20; 30) aus einer Halbleiterlegierung aus Cadmium, Quecksilber und Tellur vom Typ $Cd_xHg_{1-x}Te$ oder einer Halbleiterlegierung aus Indium, Gallium und Arsen vom Typ $In_xGa_{1-x}As$ oder einer Halbleiterlegierung aus Indium, Arsen, Antimon vom Typ $InAs_xSb_{1-x}$ besteht.

12. Fotodiode (1; 3; 4) nach einem der Ansprüche 7 bis 11, **dadurch gekennzeichnet, dass** der erste dotierte Bereich (13; 23; 33; 43) einen einzelnen Vorsprung (132; 232; 432) aufweist, der in der Mitte des Basisabschnitts (131; 231; 431) angeordnet ist.

13. Fotodiode (5) nach einem der Ansprüche 7 bis 11, **dadurch gekennzeichnet, dass** der erste dotierte Bereich (53) zumindest zwei Vorsprünge (532) aufweist, die sich am Umfang des Basisabschnitts (531) befinden.

14. Fotodiodenmatrix (200; 300; 400; 500), **dadurch gekennzeichnet, dass** die Fotodioden Fotodioden nach einem der Ansprüche 7 bis 13 sind, wobei die mehreren ersten dotierten Bereiche (13; 23; 33; 43; 53) in derselben Nutzschicht (10; 20; 30) angeordnet sind und jeweils einen PN-Übergang (15; 25) mit einem zweiten, den Fotodioden gemeinsamen dotierten Bereich (14; 24; 44; 54) bilden.

15. Fotodiodenmatrix (200; 300) nach Anspruch 14, **dadurch gekennzeichnet, dass** der zweite dotierte Bereich (24) aufweist:

   - zumindest eine sogenannte Absorptionszone (28; 38), die sich unter jedem PN-Übergang (25) befindet; und
   - zumindest eine sogenannte überdotierte Zone (27; 37), die sich zwischen zwei benachbarten PN-Übergängen (25) befindet und eine höhere Dotierungsdichte als die Absorptionszone (28; 38) aufweist.

## Claims

1. A method for manufacturing a photodiode (1; 3; 4; 5) comprising a useful layer (10; 20; 30) of a semiconducting alloy, the useful layer having a decreasing gap value from a first face called an upper face (108; 208; 308; 408; 508) to an opposite face called a lower face (109; 409; 509), said method comprising a step of making a first doped region (13; 23; 33; 43; 53) located in the useful layer and forming a PN junction (15; 25) with a second doped region (14; 24; 44; 54) of the useful layer, **characterised in that** making the first doped region comprises:

   - a first doping step (103), so as to make a part forming a base (131; 231; 431; 531) of the first doped region; and
   - a second doping step (104), so as to make at least one protrusion (132; 232; 432; 532) of the first doped region, said protrusion projecting from the part forming the base and towards the lower face (109; 409; 509) of the useful layer, so that the mean gap value in the protrusion (132; 232; 432; 532) is lower than the mean gap value in the part forming the base (131; 231; 431; 531).

2. The method according to claim 1, **characterised in that**:

   - the first doping step (103) comprises a first ion implantation implementing a first implantation energy ($E_1$) and a first implantation surface area ($S_1$); and
   - the second doping step (104) comprises a second ion implantation, implementing a second implantation energy ($E_2$) and a second implantation surface area ($S_2$), the second implantation energy being greater than the first implantation energy, and the second implantation surface area being at least twice smaller than the first implantation surface area.

3. The method according to claim 1, **characterised in that**:

   - the first doping step comprises dopant diffusion, implementing a first diffusion surface area; and
   - the second doping step comprises ion implantation implementing a second implantation surface area, the second implantation surface area being at least twice smaller than the first diffusion surface area.

4. A method for manufacturing a photodiode array (200; 300; 400; 500), **characterised in that** each photodiode is manufactured by a manufacturing method according to any of claims 1 to 3, the plural first doped regions (13; 23; 33; 43; 53) being located in a same useful layer (10; 20; 30) and each forming a PN junction (15; 25) with a second doped region (14; 24; 44; 54) common to the photodiodes.

5. The method for manufacturing a photodiode array (200; 300) according to claim 4, **characterised by** a step (206; 307) of making at least one so-called over-doped zone (27; 37), located in the second doped region (24) and between two neighbouring PN junctions (25), the over-doped zone (27; 37) having a doping density greater than that of at least one so-called absorption zone (28; 38) located in the second doped region (24) and under each PN junction (25).

6. The method for manufacturing a photodiode array (300) according to claim 5, **characterised in that** the over-doped zone (37) is made when epitaxially growing the useful layer, by making (307) an over-doped layer (30') of the useful layer, flush with the upper face (308) of the useful layer, and forming, after making the first doped regions (33), the over-doped zone (37).

7. A photodiode (1; 2; 3; 4; 5) comprising a useful layer (10; 30) of a semiconducting alloy, the useful layer having:

   - a decreasing gap value, from a first face of the useful layer called an upper face (108; 208; 308; 408; 508) to an opposite face called a lower face (109; 409; 509), and
   - a PN junction (15; 25), between a first doped region (13; 23; 33; 43; 53) and a second doped region (14; 24; 44; 54) surrounding the first doped region;

   **characterised in that** the first doped region (13; 23; 33; 43; 53) comprises:

   - a part forming a base (131; 231; 431; 531); and
   - at least one protrusion (132; 232; 432; 532), projecting from the part forming the base (131; 231; 431; 531) and towards the lower face (109; 409; 509) of the useful layer, so that the mean gap value in the protrusion (132; 232; 432; 532) is lower than the mean gap value in the part forming the base (131; 231; 431; 531).

8. The photodiode (1; 2; 3; 4; 5) according to claim 7, **characterised in that** the protrusion (132; 232; 432; 532):

   - extends in the useful layer (10; 30) at least 1.2 times deeper than the part forming the base (131; 231; 431; 531); and
   - has a cross-sectional area in a plane parallel to the plane of the upper face of the useful layer, at least twice smaller than the cross-sectional area of the part forming the base (131; 231; 431; 531) in a plane parallel to the plane of the upper face of the useful layer.

9. The photodiode (1; 2) according to claim 7 or 8, **characterised in that** the useful layer consists of a lower useful layer (10A; 20A) having a first gap value and an upper useful layer (10B; 20B) having a second gap value greater than said first value, and **in that** the base (131; 231) only extends in the upper useful layer (10B; 20B) and **in that** the protrusion (132; 232) extends at least in the lower useful layer (10A; 20A).

10. The photodiode according to claim 7 or 8, **characterised in that** the useful layer (10) has a continuous variation in the gap value, the latter decreasing from the upper face (108) to the lower face (109) of the useful layer.

11. The photodiode (1; 3; 4; 5) according to any of claims 7 to 10, **characterised in that** the useful layer (10; 20; 30) is of a $Cd_xHg_{1-x}Te$ type cadmium, mercury and tellurium semiconducting alloy, or an $In_xGa_{1-x}As$ type indium, gallium and arsenic semiconducting alloy, or an $InAs_xSb_{1-x}$ type indium, arsenic antimony semiconducting alloy.

12. The photodiode (1; 3; 4) according to any of claims 7 to 11, **characterised in that** the first doped region (13; 23; 33; 43) has a single protrusion (132; 232; 432) positioned in the centre of the part forming the base (131; 231; 431).

13. The photodiode (5) according to any of claims 7 to 11, **characterised in that** the first doped region (53) has at least two protrusions (532) located at the periphery of the part forming the base (531).

14. A photodiode array (200; 300; 400; 500), **characterised in that** the photodiodes are photodiodes according to any of claims 7 to 13, the plural first doped regions (13; 23; 33; 43; 53) being located in a same useful layer (10; 20; 30) and each forming a PN junction (15; 25) with a second doped region (14; 24; 44; 54) common to the photodiodes.

15. The photodiode array (200; 300) according to claim 14, **characterised in that** the second doped region (24) comprises:

    - at least one so-called absorption zone (28; 38), located under each PN junction (25); and
    - at least one so-called over-doped zone (27; 37), located between two neighbouring PN junctions (25), and having a doping density greater than that of the absorption zone (28; 38).

FIG.1A

FIG.1B

FIG.1C

FIG.2

FIG.3A

FIG.3B

FIG.4A

FIG.4B

FIG.5A

FIG.5B

**EP 3 012 876 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4791467 A
- US 20030071221 A
- US 20080067620 A
- JP 2955983 B
- US 20070034898 A

**Littérature non-brevet citée dans la description**

- **J.M. ARIAS.** MBE HgCdTe Heterostructure p-on-n Planar Infrared Photodiodes. *Journal of Electronic Materials,* 1993, vol. 22 (8